Europäisches Patentamt

European Patent Office

Office européen des brevets

(11) Veröffentlichungsnummer: **0 367 844**
**A1**

# EUROPÄISCHE PATENTANMELDUNG

(21) Anmeldenummer: **88118519.3**

(22) Anmeldetag: **07.11.88**

(51) Int. Cl.⁵: **C04B 35/00, H01L 39/24, C04B 35/60**

(43) Veröffentlichungstag der Anmeldung:
**16.05.90 Patentblatt 90/20**

(84) Benannte Vertragsstaaten:
**AT CH DE FR GB IT LI NL SE**

(71) Anmelder: **Siemens Aktiengesellschaft**
**Wittelsbacherplatz 2**
**D-8000 München 2(DE)**

(72) Erfinder: **Wohlleben, Karl, Dr.**
**Markweg 15**
**D-8520 Erlangen(DE)**
Erfinder: **Wilhelm, Manfred Dr.**
**Teutonenstrasse 23**
**D-8500 Nürnberg(DE)**

(54) **Verfahren zur Herstellung eines sinterkeramischen Körpers aus einem Supraleitermaterial mit hoher Sprungtemperatur.**

(57) Zur Herstellung eines sinterkeramischen Körpers mit mindestens einer supraleitenden Phase eines Hoch-$T_c$-Supraleitermaterials mit erhöhter kritischer Stromdichte wird zunächst ein Sinterkörper mit der supraleitenden Phase ausgebildet. Der Sinterkörper wird dann zu einem Sinterpulver zerkleinert. Ferner wird ein Zusatzpulver mit zumindest einigen der Komponenten des Sinterpulvers hergestellt, wobei jedoch eine Komponente durch eine als Flußmittel dienende weitere Komponente teilweise substituiert ist. Das Flußmittel führt schon unterhalb der Sintertemperatur zur Ausbildung des Sinterkörpers zu einem partiellen Aufschmelzen des Zusatzpulvers. Ein Pulvergemisch aus dem Zusatzpulver und dem Sinterpulver wird dann einem uniaxialen Kompaktierungsschritt unterzogen und daran anschließend gesintert.

EP 0 367 844 A1

# Verfahren zur Herstellung eines sinterkeramischen Körpers aus einem Supraleitermaterial mit hoher Sprungtemperatur

Die Erfindung bezieht sich auf ein Verfahren zur Herstellung eines sinterkeramischen Körpers, der mindestens eine supraleitende Phase mit hoher Sprungtemperatur eines Supraleitermaterials aus einem metallische Komponenten und Sauerstoff enthaltenden Stoffsystem aufweist, bei welchem Verfahren aus einer ersten Pulvermischung von zumindest teilweise sauerstoffhaltigen Ausgangssubstanzen mit den metallischen Komponenten ein Sinterkörper mit der supraleitenden Phase ausgebildet wird, wobei ein Kompaktierungsschritt und mindestens ein Glühschritt in einer sauerstoffhaltigen Atmosphäre bei einer vorbestimmten Sintertemperatur vorgesehen werden. Entsprechende Verfahren sind z.B. in "Nature", Vol. 332, 14.4.1988, Seiten 620 bis 624 beschrieben.

Supraleitende Metalloxidverbindungen mit hohen Sprungtemperaturen $T_c$ von insbesondere über 77 K, der Verflüssigungstemperatur des Stickstoffs, sind seit einiger Zeit bekannt. Aus diesen metallische Komponenten und Sauerstoff enthaltenden Materialien lassen sich Körper mit ausgeprägt dreidimensionaler Gestalt, sogenanntes Bulk-Material, im allgemeinen auf pulvermetallurgischem Wege herstellen. Hierzu dienen als Ausgangssubstanzen vielfach Oxid- oder Karbonatpulver der beteiligten Metalle. Diese Pulver werden im gewünschten stöchiometrischen Verhältnis gemischt, dann calziniert, wobei sich die Karbonate weitgehend zersetzen, und anschließend durch Pressen kompaktiert. Der Preßling wird dann bei hohen Temperaturen eine vorbestimmte Zeitlang unter Sauerstoff gesintert. Das so zu erhaltende Material ist jedoch meist sehr inhomogen, so daß die bekannten pulvermetallurgischen Verfahren vielfach mehrmaliges Zermahlen der Sinterkörper, Mischen, Pressen und wiederholtes Sintern erforderlich machen.

In den bisher hergestellten Einkernleitern, die z.B. durch Herunterziehen eines mit einem gepulverten Hoch-$T_c$-Supraleitermaterial gefüllten Metallrohres aus beispielsweise Silber, Gold oder Platin hergestellt wurden (vgl. z.B. "Appl.Phys.Lett.", Vol. 51, No. 3, 20.7.1987, Seiten 203 und 204), ist jedoch die erreichbare kritische Stromdichte bzw. die sogenannte Stromtragfähigkeit noch sehr unbefriedigend. So hat sich gezeigt, daß derartige, mittels Sintertechnik hergestellte oxidkeramische Supraleiter bei 77 K in Abwesenheit eines magnetischen Feldes, d.h. bei einer magnetischen Induktion B = 0, bisher nur kritische Stromdichten $J_c$ bis knapp über $10^3$ A/cm$^2$ ermöglichen (vgl. z.B. "Nature", Vol. 335, 15.9.88, Seite 204). Für einen technischen Einsatz werden aber Stromdichten in der Größenordnung von mindestens $10^5$ A/cm$^2$ gefordert. Derartig hohe Stromdichten lassen sich bisher nur in Dünnfilmtechnik erreichen. Hierzu müssen z.B. Filme des Stoffsystems Y-Ba-Cu-O mittels spezieller PVD (Physical Vapor Deposition)-Prozesse epitaktisch auf besonderen Substraten aufgewachsen sein. Auch mit polykristallinen, aber hochorientierten (texturierten) Filmen der Stoffsysteme Bi-Sr-Ca-Cu-O und Tl-Ba-Ca-Cu-O, deren kristalline c-Achsen senkrecht zur jeweiligen Filmoberfläche ausgerichtet sind, können Stromdichten in der genannten Größenordnung von mindestens $10^5$ A/cm$^2$ (bei 77 K und B = 0) erreicht werden (vgl. z.B. "Appl.Phys.Lett.", Vol. 53, No. 10, 5.9.88, Seiten 919 bis 921).

Die Ursache, daß in sinterkeramischen Bulk-Materialien der bekannten Hoch-$T_c$-Supraleiter nur demgegenüber stark reduzierte Stromdichten zu messen sind, wird in der fehlenden Texturierung des Materials mit bekanntlich ausgeprägt anisotropem Ver halten seiner Stromtragfähigkeit sowie ferner in dem sogenannten "Weak-link-Verhalten" der Korngrenzen, d.h. der geschwächten Kohärenz der einzelnen Kristallite untereinander, gesehen.

Aufgrund dieser Schwierigkeiten beim Bulk-Material ist für das Stoffsystem Y-Ba-Cu-O ein Verfahren zum texturierten Erstarren aus der Schmelze entwickelt worden (vgl. z.B. "Phys.Rev.B", Vol. 37, No. 13, 1.5.1988, Seiten 7850 bis 7853). Nach diesem Verfahren hergestellte Proben aus $YBa_2Cu_3O_{7-x}$ erreichen Stromdichten $J_c$ (bei 77 K und B = 0) von etwa $1,7 \times 10^4$ A/cm$^2$. Die einzelnen Verfahrensparameter sind jedoch dabei sehr kritisch und schwer reproduzierbar. Entsprechende Probleme ergeben sich aber auch bei der Wahl dieses Verfahrens zur Herstellung anderer supraleitender Hoch-$T_c$-Cuprate (vgl. z.B. "Science", Vol. 240, 17.6.88, Seiten 1642 bis 1645).

Aufgabe der vorliegenden Erfindung ist es, das Verfahren gemäß der eingangs genannten Art dahingehend auszugestalten, daß mit ihm auf verhältnismäßig einfache Weise ein Körper mit einem oxidkeramischen Supraleitermaterial auf pulvermetallurgischem Wege zu erhalten ist, dessen kritische Stromdichte gegenüber den bekannten Bulk-Materialien erhöht ist.

Diese Aufgabe wird erfindungsgemäß dadurch gelöst, daß der Sinterkörepr zu einem Sinterpulver zerkleinert wird, daß ferner mit einer zweiten Pulvermischung unter Anwendung mindestens eines Glühschrittes ein Zusatzpulver ausgebildet wird, dessen Zusammensetzung zumindest weitgehend dieselben Komponenten wie die erste Pulvermischung enthält, wobei jedoch mindestens eine der metallischen Komponenten durch eine weitere Komponente teilweise substituiert ist, die als ein Flußmittel dient, welches bei der Sintertemperatur zu einem partiellen Aufschmelzen des Zusatzpulvers führt, und daß dann ein Pulver gemisch aus diesem Zusatzpulver und dem Sinterpulver einem uniaxialen Kompaktierungsschritt und einer sich daran anschließenden weiteren Glühbehandlung bei einer vorbestimmten Sintertemperatur in einer sauerstoffhaltigen Atmosphäre unterzogen wird.

Bei dem erfindungsgemäßen Verfahren enthält also das Zusatzpulver ein besonderes Flußmittel. Ein hierfür geeignetes Material zeichnet sich dadurch aus, daß es zum einen bei einem Zusatz zu dem Stoffsystem der ersten Pulvermischung als Substitutionsmittel für mindestens eine Komponente dieses Systems die Ausbildung der gewünschten supraleitenden Hoch-$T_c$-Phase zumindest nicht behindert, gegebenenfalls sogar fördert. Zum anderen bewirkt das Flußmittel in an sich bekannter Weise bei seinem Zusatz zu dem Stoffsystem eine Herabsetzung der Mindesttemperatur für eine partielle Verflüssigung der ersten Pulvermischung (vgl. z.B. "Jap. Journ. of Appl. Phys.", Vol. 27, No. 6, Juni 1988, Part II, Seiten L1041 bis L1043). Eine solche partielle Verflüssigung der Pulvermischung wird nämlich als vorteilhaft im Hinblick auf die Ausbildung der gewünschten supraleitenden Hoch-$T_c$-Phase angesehen. Die Mindesttemperatur für die partielle Verflüssigung legt somit die Mindesttemperatur für die Sinterung des ersten Pulvergemisches fest. Im allgemeinen liegt die optimale Sintertemperatur geringfügig oberhalb dieser Mindesttemperatur. Unter einer optimalen Sintertemperatur wird dabei die Temperatur verstanden, bei der sich ein größtmöglicher Anteil an der gewünschten Hoch-$T_c$-Phase erhalten läßt. Bei den hier in Frage kommenden supraleitenden Materialien liegt die optimale Sintertemperatur innerhalb eines engen Temperaturbereiches. Das Flußmittel führt also vorteilhaft zu einer erwünschten partiellen Verflüssigung des Zusatzpulvers und damit auch des gesamten Pulvergemischs bei einer nunmehr niedrigeren optimalen Sintertemperatur. Vor der weiteren Glühbehandlung bzw. abschließenden Sinterung soll das Pulvergemisch aus Zusatzpulver und Sinterpulver einem uniaxia len Kompaktierungsschritt unterzogen werden. Hierdurch wird eine erwünschte Texturierung erreicht, indem bei der Sinterung der ersten Pulvermischung entstandene Kristalle mit der mindestens einen supraleitenden Hoch-$T_c$-Phase zumindest teilweise in die Kompaktierungsrichtung ausgerichtet werden. Die sich daran anschließende weitere Glühbehandlung (abschließende Sinterung) kann nun infolge des beteiligten Flußmittels bei niedrigerer Temperatur erfolgen, wobei die von der vorangegangenen Glühbehandlung des Sinterpulvers bereits vorliegenden supraleitenden Kristalle des Sinterpulvers auch in ihrer Texturierung weitgehend erhalten bleiben. Bei dieser (niedrigeren) Sintertemperatur wird eine entsprechende Hoch-$T_c$-Phase in dem das Flußmittel enthaltenden Stoffsystem des Zusatzpulvers ausgebildet. Die weitere Glühbehandlung führt dabei auch zu einer Verschweißung der supraleitenden Kristalle. Aus diesem Grunde zeigen nach dem erfindungsgemäßen Verfahren hergestellte Körper vorteilhaft eine deutlich höhere kritische Stromdichte als entsprechende bekannte Bulk-Materialien.

Vorteilhafte Ausgestaltungen des erfindungsgemäßen Verfahrens gehen aus den Unteransprüchen hervor.

Die Erfindung wird nachfolgend anhand eines Ausführungsbeispieles noch weiter erläutert. Hierzu sei von einem speziellen 5-komponentigen Stoffsystem Me1-Me2-Me3-Cu-O ausgegangen. Dabei sind für die metallische Komponente Me1 die Elemente Bi oder Tl sowie für die metallischen Komponenten Me2 und Me3 jeweils ein Erdalkalimetall zu wählen. Das erfindungsgemäße Verfahren ist jedoch nicht auf dieses spezielle Stoffsystem beschränkt; d.h., es sind ebensogut auch andere mehrkomponentige oxidkeramische Hoch-$T_c$-Supraleitermaterialien zu verwenden, welche diesem speziellen Stoffsystem nicht zuzurechnen sind, zumindest teilweise andere und/oder zusätzliche metallische Komponenten und Sauerstoff enthalten und Sprungtemperaturen über 77 K aufweisen. Voraussetzung dabei ist, daß sich die Kristalle der mindestens einen supraleitenden Hoch-$T_c$-Phase durch uniaxiale Kompaktierung ausrichten lassen.

Innerhalb des ausgewählten Stoffsystems sei als konkretes Ausführungsbeispiel die erfindungsgemäße Herstellung eines sinterkeramischen Körpers aus dem supraleitenden Material $Bi_2Sr_2Ca_2Cu_3O_{10+y}$ nachfolgend beschrieben. Dieses Material weist eine bei ca. 110 K supraleitende Phase mit 3 Cu-Schichten pro Kristall auf, wobei diese Kristalle plättchenartige Strukturen bilden. Um ein Material mit diesen Strukturen zu erhalten, wird zunächst eine erste Pulvermischung von zumindest teilweise sauerstoffhaltigen Ausgangssubstanzen der metallischen Komponenten des Stoffsystems hergestellt. Als Ausgangssubstanzen können insbesondere Oxide oder Karbonate der metallischen Komponenten des supraleitenden Materials vorgesehen werden. Es ist aber auch gegebenenfalls möglich, einzelne der metallischen Komponenten in elementarer Form als Pulver einzusetzen. Als günstig im Hinblick auf die Stöchiometrie der gewünschten supraleitenden Hoch-$T_c$-Phase hat sich für die metallischen Komponenten des supraleitenden Materials ein Atomverhältnis bei der Einwaage Bi:Sr:Ca:Cu = 4:3:3:6 erwiesen. Entsprechend diesen Atomverhältnissen wird also die erste Pulvermischung z.B. aus $Bi_2O_3$-, $SrCO_3$-, $CaCO_3$- und

CuO-Pulvern zusammengestellt. Diese Pulvermischung wird anschließend mehrfach in Luft vorgeglüht, und zwar jeweils 5 Stundenlang bei 800°C, 830°C und 850°C. Zwischen diesen einzelnen Glühschritten wird die Pulvermischung stets aufgemahlen, um einen homogenen Brand zu gewährleisten.

Am Ende dieser Glühbehandlung wird die Pulvermischung wiederum aufgemahlen und anschließend zu einem kompakten Vorprodukt kompaktiert, beispielsweise mit einem Druck zwischen 0,1 und 10 kbar, vorzugsweise mit 3 kbar gepreßt. Dieses Vorprodukt wird dann zwischen 50 und 200 Stundenlang, beispielsweise 100 Stundenlang bei 873°C in Luft gesintert. Bei dieser in einem optimalen, sehr engen Bereich liegenden Temperatur tritt ein im Hinblick auf die Ausbildung der Hoch-$T_c$-Phase als vorteilhaft anzusehendes partielles Aufschmelzen des Materials auf.

Nach dieser (ersten) Sinterung liegt ein Sinterkörper vor, der zumindest zu einem erheblichen Teil Kristalle der gewünschten supraleitenden 110 K-Phase enthält. Eine Texturierung ist jedoch nicht zu beobachten. Deshalb und wegen des hohen Porenanteils in dem Sinterkörper ist die kritische Stromdichte $J_c$ dieses Körpers nur gering. Schließlich wird der Sinterkörper zerkleinert, beispielsweise gemahlen. Die Zerkleinerung wird dabei vorteilhaft nur so weit vorgenommen, daß die ausgebildeten plättchenartigen Kristalle der supraleitenden Phase erhalten bleiben. Dementsprechend wird gemäß dem gewählten Ausführungsbeispiel eine Partikelgröße zwischen 10 und 150 $\mu$m, vorzugsweise größer als etwa 20 $\mu$m vorgesehen. Gegebenenfalls kann man noch bei der Zerkleinerung entstandene Partikel anderer Größen beispielsweise durch Sieben abtrennen oder anderweitig aussortieren. Am Ende dieses Verfahrensschrittes liegt dann ein Sinterpulver vor, das verhältnismäßig grobe plättchenförmige Partikel mit der gewünschten 110 K-Phase zumindest enthält.

Gemäß der Erfindung wird zusätzlich zu dem Sinterpulver noch ein Zusatzpulver hergestellt, das dem Sinterpulver zuzumischen ist. Für dieses Zusatzpulver wird von einer zweiten Pulvermischung ausgegangen, die zumindest weitgehend dieselben Komponenten wie die erste Pulvermischung (zur Herstellung des Sinterpulvers) enthält. Vorteilhaft wird von demselben Stoffsystem Bi-Sr-Ca-Cu-O ausgegangen, wobei lediglich die Bi-Komponente in an sich bekannter Weise teilweise durch das Flußmittel Pb substituiert ist (vgl. z.B. "Jap. Journ. of Appl. Phys.", Vol. 27, No. 6, Juni 1988, Part II, Seiten L1041-L1043). Der mit dem Pb substituierte Anteil des Bi soll vorteilhaft zwischen 10 und 30 Atom-% betragen. Die Pb-Komponente wird der zweiten Pulvermischung z.B. als PbO-Pulver beigegeben. Es zeigt sich nämlich, daß durch Zusatz von PbO bei der Präparation von supraleitendem Bi-Sr-Ca-Cuprat ein hoher Anteil an der 110 K-Phase des supraleitenden Materials entstehen kann. Durch Anwesenheit von PbO bei der Präparation kann die Sintertemperatur um etwa 10 bis 15°C gesenkt werden, da der für optimales Wachstum der 110 K-Phase notwendige Flux bei Anwesenheit von PbO bereits bei tieferer Temperatur wirksam ist. Die so hergestellte zweite Pulvermischung wird anschließend zwischen 800°C und 850°C geglüht und danach zu dem Bi(Pb)-Sr-Ca-Cu-O-Zusatzpulver aufgemahlen.

Gegebenenfalls kann die zweite Pulvermischung wie die erste Pulvermischung auch mehrmals vorgeglüht und zwischendurch aufgemahlen werden. Die Partikelgröße dieses Pulvers wird vorteilhaft so eingestellt, daß sie kleiner als die des Sinterpulvers ist. Hierdurch wird eine Ausrichtung der gröberen plättchenartigen Kristalle des Sinterpulvers bei der noch vorzunehmenden uniaxialen Kompaktierung nicht behindert. Im allgemeinen sollte deshalb die Partikelgröße des Zusatzpulvers unter 10 $\mu$m liegen.

Die Zusammensetzung der zweiten Pulvermischung bzw. des Zusatzpulvers braucht nicht unbedingt hinsichtlich der Stöchiometrie der Zusammensetzung der ersten Pulvermischung zu entsprechen. Gegebenenfalls ist es auch möglich, davon abweichende Anteile der einzelnen Komponenten vorzusehen. Dies kann insbesondere dann von Vorteil sein, wenn man z.B. durch einen höheren Ca- und/oder Cu-Gehalt die Ausbildung von Phasen mit höheren Sprungtemperaturen unterstützen will.

Mit dem somit feineren Zusatzpulver und dem gröberen Sinterpulver wird dann ein Pulvergemisch erstellt, wobei der Anteil des Zusatzpulvers in dem Gemisch bei etwa 1 bis 30 Gew.-% des Anteils des Sinterpulvers beträgt bzw. zwischen 1 und ca. 25 Gew.-% des Pulvergemischs ausmacht. Dieses Pulvergemisch wird dann uniaxial kompaktiert, wofür beispielsweise Heiß- oder Kaltpressen vorgesehen wird. Auch andere Kompaktierungsverfahren wie z.B. ein Walzen, Rollen oder Hämmern kommen in Frage. Dieser Kompaktierungsschritt führt zu einer gewünschten Texturierung zumindest des Anteils des Sinterpulvers durch Ausrichtung der Kristalle mit der Hoch-$T_c$-Phase. Nach der Verformung wird der so erhaltene Preßkörper einer (zweiten) Sinterbehandlung in einer sauerstoffhaltigen Atmosphäre unterzogen. Beispielsweise wird 100 Stundenlang bei 860°C in Luft geglüht.

Da vorteilhaft diese abschließende Glühung (zweite Sinterung) in Folge des beteiligten Flußmittels bei einer gegenüber der (ersten) Sinterung des Sinterkörpers vergleichsweise geringeren Temperatur erfolgen kann, bleiben die bei der ersten Sinterung erzeugten supraleitenden Kristalle des Sinterpulvers auch in ihrer Texturierung weitgehend erhalten. Mit der abschließenden zweiten Sinterung wird eine Verschweißung dieser supraleitenden Kristalle innerhalb des auszubildenden sinterkeramischen Körpers erreicht.

Durch eine gleichzeitige Reduzierung des Sauerstoffpartialdruckes während der abschließenden (zweiten) Sinterung kann darüber hinaus vorteilhaft die optimale Sintertemperatur noch zusätzlich abgesenkt werden (vgl. z.B. "Jap. Journ. of Appl. Phys.", Vol. 27, No. 8, August 1988, Part II, Seiten L1476 bis L1479). Hierdurch wird die Bedingung für eine Verschweißung bei Erhalt der bereits gebildeten supraleitenden Kristalle noch verbessert. Erfolgt dementsprechend das abschließende (zweite) Sintern bei einem auf z.B. 0,1 Atmosphären reduzierten Sauer stoffpartialdruck, dann liegt die optimale Sintertemperatur für das gewählte Ausführungsbeispiel unterhalb von 850 °C, beispielsweise zwischen 830° und 845° C.

Gemäß dem gewählten konkreten Ausführungsbeispiel wurde das Stoffsystem Bi-Sr-Ca-Cu-O gewählt, dessen Bi-Komponente teilweise durch das Flußmittel Pb substituiert wurde. Nach dem Verfahren gemäß der Erfindung lassen sich ebensogut auch andere mehrkomponentige oxidkeramische Hoch-$T_c$-Materialien herstellen, die zumindest teilweise andere Komponenten aufweisen. Voraussetzung hierfür ist, daß sich die Hoch-$T_c$-Phase des gewählten Stoffsystems durch eine Sinterung bei einer optimalen Sintertemperatur ausbilden läßt, bei der mit Hilfe eines Flußmittels ein partielles Aufschmelzen des Materials zu beobachten ist und die gegenüber der optimalen Sintertemperatur bei fehlendem Flußmittel vergleichsweise niedriger ist. So kann beispielsweise ein sinterkeramischer Körper mit einer gewünschten supraleitenden Hoch-$T_c$-Phase des Stoffsystems Tl-Ba-Ca-Cu-O mit verhältnismäßig hoher kritischer Stromdichte erhalten werden, bei dessen Zusatzpulver die Tl-Komponente teilweise durch das Flußmittel Pb ersetzt wurde. Neben diesem bekannten Flußmittel können auch andere Flußmittel eingesetzt werden, welche die geforderten Eigenschaften erfüllen. Beispiele hierfür sind In, Sn oder Sb.

Das erfindungsgemäße Verfahren zeichnet sich insbesondere dadurch aus, daß es zu sinterkeramischen Körpern führt, deren kritische Stromdichte mindestens eine Größenordnung höher liegt als die von Bulk-Materialien, die nach dem bekannten Verfahren gemäß der eingangs genannten Veröffentlichung "Nature", Vol. 332 hergestellt werden.

**Ansprüche**

1. Verfahren zur Herstellung eines sinterkeramischen Körpers, der mindestens eine supraleitende Phase mit hoher Sprungtemperatur eines Supraleitermaterials aus einem metallische Komponenten und Sauerstoff enthaltenden Stoffsystem aufweist, bei welchem Verfahren aus einer ersten Pulvermischung von zumindest teilweise sauerstoffhaltigen Ausgangssubstanzen mit den metallischen Komponenten ein Sinterkörper mit der supraleitenden Phase ausgebildet wird, wobei ein Kompaktierungsschritt und mindestens ein Glühschritt in einer sauerstoffhaltigen Atmosphäre bei einer vorbestimmten Sintertemperatur vorgesehen werden, **dadurch gekennzeichnet,**
- daß der Sinterkörper zu einem Sinterpulver zerkleinert wird,
- daß ferner mit einer zweiten Pulvermischung unter Anwendung mindestens eines Glühschrittes ein Zusatzpulver ausgebildet wird, dessen Zusammensetzung zumindest weitgehend dieselben Komponenten wie die Pulvermischung enthält, wobei jedoch mindestens eine der metallischen Komponenten durch eine weitere Komponente teilweise substituiert ist, die als ein Flußmittel dient, welches schon unterhalb der Sintertemperatur der ersten Pulvermischung zu einem partiellen Aufschmelzen des Zusatzpulvers führt,
und
- daß dann ein Pulvergemisch aus diesem Zusatzpulver und dem Sinterpulver einem uniaxialen Kompaktierungsschritt und einer sich daran anschließenden weiteren Glühbehandlung bei einer vorbestimmten Sintertemperatur in einer sauerstoffhaltigen Atmosphäre unterzogen wird.

2. Verfahren nach Anspruch 1, **dadurch gekennzeichnet,** daß für die weitere Glühbehandlung eine Sintertemperatur vorgesehen wird, bei der in dem Stoffsystem des Zusatzpulvers eine entsprechende supraleitende Phase ausgebildet wird.

3. Verfahren nach Anspruch 1 oder 2, **dadurch gekennzeichnet,** daß die weitere Glühbehandlung bei einer Sintertemperatur durchgeführt wird, die vergleichsweise niedriger als die Sintertemperatur des Glühschrittes zur Ausbildung des Sinterkörpers ist.

4. Verfahren nach einem der Ansprüche 1 bis 3, **dadurch gekennzeichnet,** daß die weitere Glühbehandlung in einer Atmosphäre mit reduziertem Sauerstoffpartialdruck durchgeführt wird.

5. Verfahren nach einem der Ansprüche 1 bis 4, **dadurch gekennzeichnet,** daß als uniaxialer Kompaktierungsschritt ein Heiß- oder Kaltpressen oder ein Walzen oder ein Hämmern vorgesehen wird.

6. Verfahren nach einem der Ansprüche 1 bis 5, **dadurch gekennzeichnet,** daß zur Ausbildung des Sinterkörpers die erste Pulvermischung mehrfach vorgeglüht wird, wobei zwischen den Glühschritten jeweils ein Aufmahlen vorgesehen wird.

7. Verfahren nach einem der Ansprüche 1 bis 6, **dadurch gekennzeichnet,** daß der Sinterkörper zu einem Sinterpulver zerkleinert wird, dessen Partikel Abmessungen in der Größenordnung der die supraleitende Phase aufweisenden Kristalle haben.

8. Verfahren nach einem der Ansprüche 1 bis 7, **dadurch gekennzeichnet,** daß eine Partikelgröße des Sinterpulvers zwischen 10 $\mu$m und 150 $\mu$m vorgesehen wird.

9. Verfahren nach einem der Ansprüche 1 bis 8, **dadurch gekennzeichnet,** daß für das Zusatzpulver eine maximale Partikelgröße vorgesehen wird, die kleiner als die Partikelgröße der Kristalle mit der supraleitenden Phase in dem Sinterpulver ist.

10. Verfahren nach einem der Ansprüche 1 bis 9, **dadurch gekennzeichnet,** daß eine Partikelgröße des Zusatzpulvers unter 10 $\mu$m vorgesehen wird.

11. Verfahren nach einem der Ansprüche 1 bis 10, **dadurch gekennzeichnet,** daß ein Pulvergemisch mit einem Anteil des Zusatzpulvers zwischen 1 und 25 Gew.-% vorgesehen wird.

12. Verfahren nach einem der Ansprüche 1 bis 11, **dadurch gekennzeichnet,** daß ein Zusatzpulver vorgesehen wird, dessen mindestens eine metallische Komponente zu 10 bis 30 Atom-% durch die als Flußmittel dienende metallische Komponente substituiert wird.

13. Verfahren nach einem der Ansprüche 1 bis 12, **dadurch gekennzeichnet,** daß ein oxidkeramisches Sintermaterial des Stoffsystems Me1-Me2-Me3-Cu-O hergestellt wird, wobei die metallische Komponente Me1 Bi oder Tl sowie die metallischen Komponenten Me2 und Me3 jeweils ein Erdalkalimetall zumindest enthalten.

14. Verfahren nach einem der Ansprüche 1 bis 13, **dadurch gekennzeichnet,** daß als Flußmittel dienende metallische Komponente des Zusatzpulvers Pb oder In oder Sn oder Sb vorgesehen wird.

**Europäisches Patentamt**

# EUROPÄISCHER RECHERCHENBERICHT

Nummer der Anmeldung

EP 88 11 8519

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 285 960 (SIEMENS AG) * Ansprüche 1-12; Spalte 2, Zeile 5 - Spalte 3, Zeile 25 * --- | 1-13 | C 04 B 35/00 H 01 L 39/24 C 04 B 35/60 |
| A,D | JAPANESE JOURNAL OF APPLIED PHYSICS, Band 27, Nr. 8, August 1988, Seiten L1476-L1479; U. ENDO et al.: "Preparation of the high-Tc phase of Bi-Sr-Ca-Cu-O superconductor" * Seiten L1476-1477 * ----- | 1,14 | |

**RECHERCHIERTE SACHGEBIETE (Int. Cl.5)**

C 04 B
H 01 L

Der vorliegende Recherchenbericht wurde für alle Patentansprüche erstellt

| Recherchenort | Abschlußdatum der Recherche | Prüfer |
|---|---|---|
| DEN HAAG | 05-07-1989 | LUETHE H. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)